# EUROPEAN PATENT APPLICATION

(11) **EP 1 552 905 A2**
(43) Date of publication of application: **13.07.2005**
(21) Application number: 02714426.0
(22) Date of filing: 03.04.2002
(51) Int. Cl.: B24D 15/04, B24D 11/00, H01L 21/66, G01R 1/06, G01R 31/28

(54) **CONTACTOR CLEANING SHEET, CONTACTOR CLEANING SHEET MANUFACTURING METHOD, AND CONTACTOR CLEANING METHOD**

(30) Priority: 02.05.2001 JP 2001135090
(71) Applicant: Nihon Micro Coating Co., Ltd., Akishima-City, Tokyo 196-0021 (JP)
(72) Inventor: SATO, Satoru, Akishima-shi, Tokyo 196-0021 (JP); SAKAMOTO, Akihiro, Akishima-shi, Tokyo 196-0021 (JP)
(74) Representative: Lerwill, John
(86) International application number: PCT/JP2002/003335
(87) International publication number: WO 2002/090054

(57) **Abstract**

A cleaning sheet has a base sheet, a foamed layer of a porous material on the base sheet and a polishing layer formed on the foamed layer. The foamed layer includes abrading particles and air bubbles. Such a cleaning sheet may be produced by preparing a paint having air bubbles dispersed inside by mechanically foaming a foaming material containing a foaming resin material and abrading particles, forming on the base sheet a foamed layer having abrading particles dispersed inside by coating a surface of the base sheet with this paint and drying it, and forming a polishing layer on the foamed layer. A probe having a tip may be cleaned with such a cleaning sheet by causing a surface of its polishing layer to be pressed against the tip of the probe and causing the tip of the probe to penetrate the polishing layer and further to be inserted into the foamed layer having abrading particles dispersed inside.

## Description

### Technical Field

This invention relates to a cleaning sheet for and a method of removing foreign substances attached to the tip and side surfaces of a probe used for inspecting a planar target object such as a semiconductor device having integrated circuits installed thereon.

### Background of the Art

Chips are produced by installing semiconductor elements and integrated circuits on a semiconductor wafer through various wafer-producing processes. The chips thus produced on a semiconductor wafer are cut off from the wafer after a current-passing test and are packaged. Tests with a current are carried out also before and after the packaging to separate faulty products stringently from qualified products.

Such current-passing tests are carried out by means of a test apparatus of a known kind such as a wafer prober. A position-matching process by moving a prober needle ("probe") serving as an electrode of a tester and the electrodes on the chip (pads or lead lines) and a contacting process between the probe and the chip electrodes are repeated for carrying out electrical measurements of different kinds.

While such position-matching and contacting processes are repeated by moving the probe and the electrodes on the chips, the tip of the probe slides over the electrodes on the chips, scraping off portions of the electrodes. Such portions of the electrodes that have been scraped off become attached to the tip and the side surfaces of the probe as foreign substances.

The foreign substances, that thus become attached to the probe, are metals such as aluminum. If such a metal is oxidized, the electrical contact resistance between the probe and the electrodes on the chip becomes larger, making it impossible to carry out accurate electrical measurements. Thus, it is necessary to clean the tip portion of the probe regularly after each time a specified number of contact processes have been carried out in order to remove such foreign substances from the probe.

Removal of such foreign substances from the tip portion of a probe is carried out by using the same apparatus used for the current-passing tests such as the aforementioned wafer prober, except the target object to be tested such as a semiconductor wafer attached to the apparatus is replaced with a cleaning device having a similar shape. Examples of a prior art cleaning device of this kind include hard polishing plates of a grinding stone, glass and a ceramic material (as disclosed, for example, in Japanese Patent Publications Tokkai 7-199141, 5-209896, 5-166893, 4-96342 and 3-105940) and sheets with a polishing layer formed on an uneven surface of an elastic member having protrusions and indentations (as disclosed, for example, in Japanese Patent Publication Tokkai 2000-332069). The probe is pressed against the surface of such a cleaning device, as done in the aforementioned current-passing test.

If a polishing plate of a hard material is used as the cleaning device and the probe is pressed too hard against it, its tip portion will become deformed and hence it is necessary to reduce the pressure with which the probe can be pressed against the cleaning device. As a result, only the portions very close to the tip can be cleaned. If a cleaning device of the type with a polishing layer formed on an elastic member is used, on the other hand, the tip of the probe penetrates the polishing layer and cannot be cleaned sufficiently. Thus, the common practice has been to provide separately a device for cleaning the tip and another device for cleaning the side surfaces, attaching them to a current-passing test apparatus consecutively one at a time. It was therefore both cumbersome and time-consuming to clean a probe.

### Summary of the Invention

It is therefore an object of this invention in view of the above to provide a cleaning sheet capable of cleaning both the tip and the side surfaces of a probe, a method of producing such a sheet and also a method of cleaning a probe.

A cleaning sheet embodying this invention, with which the above and other objects can be accomplished, may be characterized as comprising a base sheet, a foamed layer of a porous material which is formed on the base sheet and includes abrading particles and air bubbles, and a polishing layer formed on the foamed layer.

Such a cleaning sheet may be produced by preparing a paint having air bubbles dispersed therein by mechanically foaming a foaming material comprising a foaming resin material and abrading particles, forming on a base sheet a foamed layer having abrading particles dispersed inside by coating a surface of the base sheet with this paint and drying it, and forming a polishing layer on a surface of the foamed layer.

Such paint may be produced by sending air into the foaming material while stirring the foaming material and thereby dispersing the air bubbles and the abrading particles inside the paint. Because it is by a mechanical means that the foaming material is caused to be foamed, the abrading particles and the air bubbles can be dispersed uniformed throughout the interior of the foamed layer without strictly maintaining the conditions for the foaming reaction such as the reaction time and temperature.

A probe having a tip may be cleaned with a cleaning sheet embodying this invention, structured and produced as described above, by causing a surface of its polishing layer to be pressed against the tip of the probe and thereby causing the tip of the probe to penetrate the polishing layer and further to be inserted into the foamed layer having abrading particles dispersed inside. As the tip penetrates the polishing layer and becomes inserted into the foamed layer having abrading particles dispersed inside, both the tip and the side surfaces of the probe become cleaned not only by the abrading particles inside the polishing layer but also those in the foamed layer.

In summary, with a cleaning sheet thus structured and/or produced, the tip and the side surfaces of a probe can be effectively and simultaneously cleaned.

### Brief Description of the Drawings

Fig. 1 is a sectional view of a cleaning sheet embodying this invention when a tip portion of a probe is being cleaned therewith.
Fig. 2 is a schematic side view of a wafer prober.

### Detailed Description of the Invention

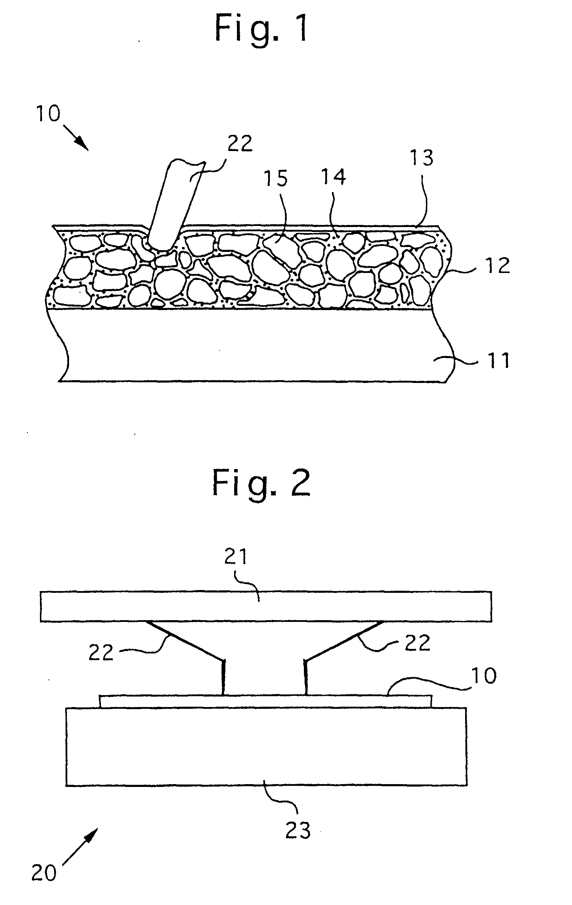

Fig. 2 shows a wafer prober 20 of a known kind. When a cleaning process according to this invention is effected, a cleaning sheet 10 embodying this invention to be described below and shown in Fig. 1 is attached to such a wafer prober 20 instead of a target object to be inspected such as a semiconductor wafer which is normally attached thereto. As shown in Fig. 1, the cleaning sheet 10 is comprised of a base sheet 11, a foamed layer 12 formed on a surface of the base sheet 11 and a polishing layer 13 formed on the surface of the foamed layer 12. The foamed layer 12 is a layer of a porous foamed material containing abrading particles 14 and many air bubbles inside. Such a cleaning sheet may be produced by first preparing a paint material by mechanically foaming a material including a foaming resin and abrading particle. A surface of the base sheet 11 is then coated with this paint material and it is dried so as to form the foamed layer 12 with the abrading particles dispersed therein. The polishing layer 13 is thereafter formed on the surface of this foamed layer 12.

The foaming material to be used in the production method described above may be obtained by mixing a foaming agent such as a salt of fatty acid, an acrylic thickener, a fluorine or silicon type stabilizer, and also powder of aluminum hydroxide with average diameter of 0.01-70µm for improving the stabilization effect, and further by mixing in an epoxy cross linking agent. As the abrading particles 14, particles of aluminum oxide, silicon carbide, chromium oxide, iron oxide, diamond, boron carbide, cerium oxide or silicon oxide with average diameter of 0.01-70µm are also mixed into the foaming material in an amount of 5-80 weight %.

The mechanical foaming of the foaming material thus prepared is effected with stirring while sending in air at a specified rate into the foaming material containing the abrading particles 14. As a result of this process, the abrading particles 14 and the air bubbles 15 become uniformly dispersed inside the foaming material and a paint with a high degree of viscosity containing air bubbles is obtained. The foaming multiplicity of the paint is in the range of 2-5 times. Such a mechanical foaming process may be carried out by using a continuous high-pressure foaming apparatus (such as TW-70 produced by Aikosha Seisakusho of Japan) used for the continuous mixing process of raw cream.

The paint material with air bubbles may be applied on a surface of the base sheet 11 by a known method and with a known means such as the knife coater method and the so-called direct coating method . A sheet with a flat surface of a plastic material such as polyester and polyethylene terephthalate (PET) may be used as the base sheet 11. The drying process for the paint applied on the base sheet 11 may be effected in an environment with temperature in the range of 90°C-160°C. In order to completely solidify the paint, a far infrared ray may be applied additionally. For forming a stable foamed layer 12 with abrading particles dispersed on the surface of the base sheet 11, furthermore, a ventilating means such as a fan may be used to cool it after the foaming paint coated on the surface of the base sheet 11 is completely dried. After such a drying process, a foamed layer 12 with air bubbles 15 and abrading particles 14 uniformly dispersed throughout is formed on the surface of the base sheet 11. The thickness of the foamed layer 12 thus produced is within the range of 50µm-200µm.

Since the foamed layer 12 according to this invention is formed by a mechanical foaming process rather than by a chemical method, the abrading particles and air bubbles can be uniformly dispersed without the necessity of strictly controlling and maintaining the conditions for the foaming reaction such as the reaction time and the temperature.

The polishing layer 13 may be formed by preparing a polisher paint having abrading particles dispersed within a resin solution obtained by dissolving a resin binder selected from polyesters and urethanes in a solvent such as methylethyl ketone, applying it on the surface of the foamed layer 12 by a known method such as the reverse coating method and then drying it. The thickness of the polishing layer 13 is in the range of 5µm-30µm. Particles of silicon carbide, silica, aluminum oxide and diamond with average diameter of 0.001µm-10µm may be used as the abrading particles.

A wafer prober such as shown at 20 in Fig. 2, commonly used for current-passing tests, may be used for cleaning a probe for inspecting a planar object such as a semiconductor device with integrated circuits installed thereon. As shown in Fig. 2, the wafer prober 20 has a table 23 on which a target object for inspection such as a semiconductor device is intended to be attached. After such a target object for inspection is attached, the table 23 is moved horizontally and vertically for positioning and the target object is pressed against a probe 22 of a probe card 21 in order to carry out electrical measurements of different kinds on the target object. When the probe 22 is to be cleaned, the cleaning sheet 10 as described above is attached to the table 23, instead of the target object for inspection and the table 23 is similarly moved similarly to press the probe 22 against the surface of the cleaning sheet 10 attached to the table 23.

The cleaning sheet 10 may be cut into a circular, quadrangular or any other shape and pasted on the table 23 by means of a double-side adhesive sheet. Alternatively the cleaning sheet 10 may be pasted on a flat plate of an appropriate shape and this plate may then be attached to the table 23. In summary, the manner of attaching the cleaning sheet 10 onto the table 23 does not limit the scope of the invention.

When the tip of the probe 22 is pressed against the surface of the cleaning sheet 10, it penetrates the polishing layer 13 as shown in Fig. 1 and is inserted inside the foamed layer 12 with abrading particles. Both the tip and side surfaces of the probe 22 are cleaned by the abrading particles in the polishing layer 13 as the probe 22 penetrates the polishing layer 13 and thereafter by the abrading particles 14 dispersed in the foamed layer 12. In summary, since both the tip and side surfaces of the probe 22 are also cleaned by the foamed layer 12, those of the foreign materials not removed as the probe penetrates the polishing layer 13 may be expected to be dependably removed inside the foamed layer 12 from the tip and the side surfaces of the probe 22.

As a test, a cleaning sheet embodying this invention was produced by adding 2.9kg of particles of aluminum hydroxide (HM-43 by tradename produced by Dai-Nippon Inki Kagaku Kogyo Corporation) for improving the stabilization effect and 2.9kg of particles of aluminum oxide (WA8000 by tradename produced by Fujimi Incorporated) to 28kg of foaming urethane resin (DICFORM F-505EL by tradename produced by Dai-Nippon Inki Kagaku Kogyo Corporation), mixing them together in a pot mill for 96 hours and thereafter producing a foaming material by further adding thereto 8.7kg of a foaming agent (F-1 by tradename produced by Dai-Nippon Inki Kagaku Kogyo Corporation), 0.29kg of a stabilizer (NBA-1 by tradename produced by Dai-Nippon Inki Kagaku Kogyo Corporation) and 0.58kg of a cross linking agent (CATALYST/PA-20 by tradename produced by Dai-Nippon Inki Kagaku Kogyo Corporation), further mixing in 0.87kg of a hardening agent (DR-5L by tradename produced by Dai-Nippon Inki Kagaku Kogyo Corporation) and 1.45kg of a thickener (VONCOAT 3750 by tradename produced by Dai-Nippon Inki Kagaku Kogyo Corporation), and producing a paint with air bubbles by foaming this material by using a continuous high-pressure foaming machine (TW-70 by tradename produced by Aikosha Seisakusho). This paint was applied on a polyethylene terephthalate (PET) sheet with thickness of 75µm running at a rate of 2.0m/minute by means of a knife coater to a thickness of 400µm. After it was dried in an environment of 100°C, it was further dried by far infrared irradiation (120°C and 140°C) and cooled by means of an ordinary fan for family use to form a foamed layer with dispersed abrading particles on the surface of the PET sheet.

Next, green carbon particles with average diameter of 1µm were dispersed in a resin solution obtained by dissolving a urethane resin binder by means of a solvent such as methylethyl ketone to obtain a polishing paint. This polishing paint was applied on the surface of the aforementioned foamed layer by the reverse coating method and then dried to form a polishing layer on the surface of the foamed layer and to thereby produce a cleaning sheet of the test example.

This cleaning sheet of the test example was used to clean the tip portion of a probe by using a wafer prober as shown in Fig. 2 by removing the semiconductor device which had been inspected therewith and attaching instead the aforementioned cleaning sheet of the test example. The tip portion of the probe was microscopically observed both before and after the cleaning process and it was ascertained that the metallic foreign substances found to be attached both at the tip and the side surfaces of the probe had been completely removed.

## Claims

1. A cleaning sheet comprising:
a base sheet;
a foamed layer formed on said base sheet, said foamed layer having abrading particles dispersed therein; and
a polishing layer formed on said foamed layer.

2. A method of producing a cleaning sheet, said method comprising the steps of:
producing a paint having air bubbles dispersed therein by mechanically foaming a foaming material comprising a foaming resin material and abrading particles;
forming on a base sheet a foamed layer having abrading particles dispersed therein by coating a surface of said base sheet with said paint and drying said paint; and
forming a polishing layer on a surface of said foamed layer.

3. The method of claim 2 wherein the step of producing said paint comprises the step of sending air into said foaming material while stirring said foaming material and thereby dispersing said air bubbles and said abrading particles inside said paint.

4. The method of claim 2 wherein the step of forming said polishing layer comprises the steps of:
applying a paint including a resin binder and said abrading particles on a surface of said foamed layer; and
drying said applied paint whereby said polishing layer is formed on the surface of said formed layer having said abrading particles dispersed therein.

5. A method of cleaning a probe, said probe having a tip, said method comprising the steps of:
causing a surface of said polishing layer of the cleaning sheet of claim 1 or 2 to be pressed against said tip of said probe; and
causing said tip to penetrate said polishing layer and to be thereby inserted into said foamed layer having said abrading particles dispersed therein.
